# FASCICULE DE BREVET EUROPEEN

(11) **EP 0 599 678 B1**
(45) Date de publication et mention de la délivrance du brevet: **08.05.1996**
(21) Numéro de dépôt: 93402666.7
(22) Date de dépôt: 29.10.1993
(51) Int. Cl.: H05K 7/20, H05B 3/26, H05B 3/32

(54) **Dispositif de réchauffage de cartes électroniques**
Anordnung zur Erwärmung von elektronischen Platten
Device for heating of electronic boards

(30) Priorité: 29.10.1992 FR 9212950
(43) Date de publication de la demande: 01.06.1994
(73) Titulaire: THOMSON-CSF, F-75008 Paris (FR)
(72) Inventeur: Dagnac, Pierre, F-92402 Courbevoie cédex (FR); Leviandier, Michel, F-92402 Courbevoie cédex (FR); Tigneres, Jean-Philippe, F-92402 Courbevoie cédex (FR)
(74) Mandataire: Albert, Claude

(56) Documents cités:
- EP-A- 0 059 410
- EP-A- 0 377 425
- EP-A- 0 484 852
- GB-A- 1 196 620
- GB-A- 2 198 593
- PATENT ABSTRACTS OF JAPAN vol. 015, no. 280 (E-1090) 16 Juillet 1991 & JP-A-03 097 299 (MITSUBISHI) 23 Avril 1991

## Description

La présente invention se rapporte à un dispositif de réchauffage de cartes électroniques disposées dans des guides-cartes et entre lesquelles une circulation d'air est possible.

D'une manière générale, ces cartes électroniques, quelles que soient leurs dimensions, épaisseur, technologies de composants, ... ou leur matière constitutive, peuvent être destinées à fonctionner dans des coffrets électroniques, des calculateurs ou autres matériels divers. Ces matériels peuvent être utilisés dans certains cas dans des environnements climatiques sévères et en particulier à des températures très basses, pouvant aller jusqu'à -55 à -60°C. Beaucoup de composants et en particulier les composants dits civils ne fonctionnent pas ou fonctionnent mal à de telles températures. Il est donc nécessaire d'élever leur température jusqu'à une valeur suffisante pour assurer le démarrage rapide et le fonctionnement correct des cartes électroniques.

Il est connu dans certains cas de prévoir sur chaque circuit intégré un moyen de chauffage propre (fil résistant par exemple). Mais une telle solution est coûteuse car elle exige l'utilisation de composants spécialement modifiés.

Un circuit électronique est en outre connu du EP-A-0 484 852. Ce circuit électronique contrôlé en température comporte un substrat support ayant, sur sa première face, des composants dudit circuit et, sur sa seconde face un réseau de réchauffage.

La présente invention a pour bute permettre le réchauffage de cartes électroniques standard utilisant des composants classiques sans aucune modification.

Un objet de l'invention est donc un dispositif de réchauffage de cartes électroniques simple grâce à un aménagement convenable des ensembles de montage et de support des cartes.

Selon l'invention, il est donc prévu un dispositif de réchauffage de cartes électroniques montées entre des parois guide-cartes opposées comportant des rainures de guidage parallèles et un fond assurant les interconnexions, ledit dispositif étant caractérisé en ce qu'un élément chauffant est disposé sur au moins une des parois guide-cartes, sur la face opposée aux rainures, en ce que des moyens de convection sont associés audit élément chauffant et en ce que lesdites parois guide-cartes comportent des ouïes disposées entre les rainures pour assurer la circulation de l'air chauffé entre les cartes électroniques.

L'invention prévoit aussi un dispositif de réchauffage de cartes électroniques selon la revendication 8.

Ainsi, le dispositif s'applique à tout type de cartes sans modification de celles-ci. D'autre part, le réchauffage est d'autant plus efficace qu'il s'effectue des deux côtés de chaque carte ce qui permet de chauffer les composants par le corps et par les pattes, indépendamment du sens de montage.

L'invention sera mieux comprise et d'autres caractéristiques et avantages apparaîtront à l'aide de la description ci-après et des dessins joints où :
- la figure 1 est une vue en perspective d'un mode de réalisation du dispositif selon l'invention ;
- la figure 2 est un schéma de principe du dispositif en convection naturelle ;
- les figures 3 et 4 montrent un schéma de principe du dispositif en convection forcée ; et
- la figure 5 illustre une partie d'une variante du dispositif selon l'invention.

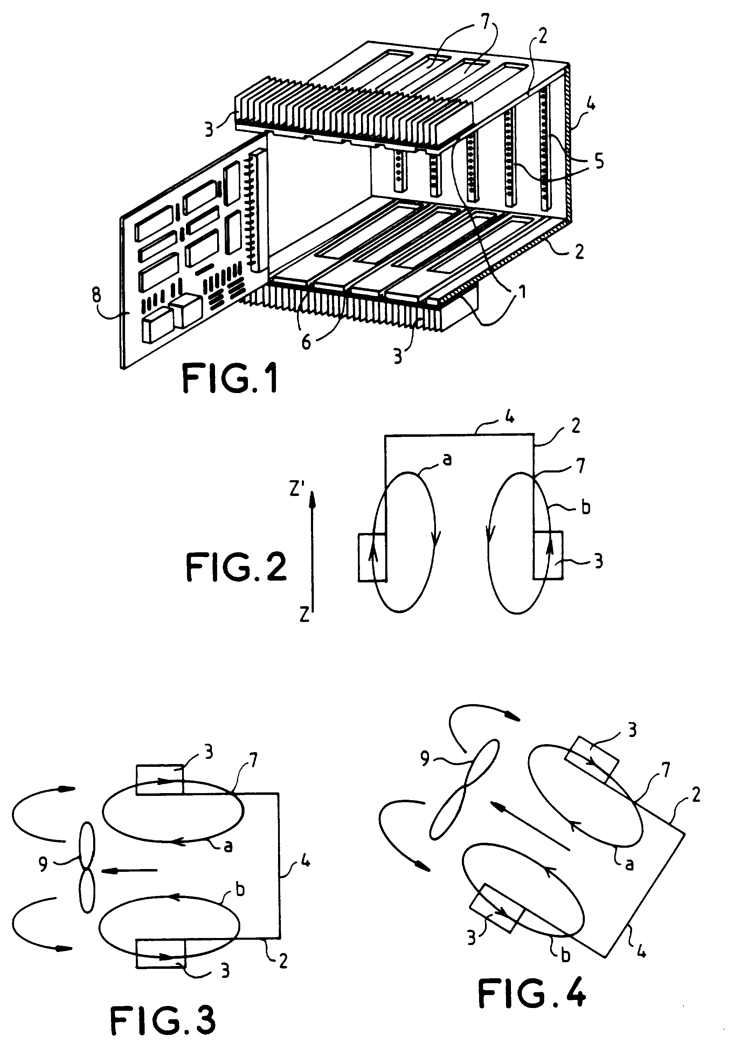

La figure 1 montre en perspective un ensemble de montage de cartes électroniques modifié pour constituer le dispositif de réchauffage selon l'invention.

Dans toute la description et les revendications, on entend par les termes "carte électronique" tout type de carte portant un certain nombre de composants électroniques reliés entre eux pour former un circuit, par exemple carte de circuit imprimé, quelles que soient les dimensions, épaisseur, technologies de composants, technologies de réalisation et quelle que soit la matière constitutive de la carte (verre epoxy, composite epoxy, polyamide céramique, etc...). Les cartes électroniques 8 sont engagées pour montage et maintien dans des rainures de guidage 6 de parois guide-cartes opposées 2. Ces parois sont

reliées à un fond 4, carte-mère ou fond de panier, muni de connecteurs 5 pour recevoir les connecteurs mâles correspondants des cartes. Ce fond 4 est prévu pour assurer les interconnexions nécessaires. Pour assurer le réchauffage des cartes selon l'invention, il est prévu de disposer sur les parois guide-cartes 2, sur la face opposée aux rainures, un élément chauffant 1. Cet élément peut être un film ou support résistif ou aussi un dispositif de circulation de fluide caloporteur ou un dispositif à effet Peltier ou tout autre moyen de chauffage connu. Cet élément de chauffage 1 peut être fixé à la paroi 2 par tout moyen tel que collage, rivetage, maintien par vis ou par plaque d'appui, etc...

Cet élément chauffant est fixé le long du côté de la paroi 2 opposé au fond 4. La paroi guide-cartes est en matériau métallique ou bon conducteur de la chaleur.

A l'élément chauffant 1 est associé un moyen de convection tel que des ailettes 3 en métal (par exemple aluminium) ou tout autre matériau bon conducteur thermique. Entre l'élément 1 avec les ailettes 3 et le fond 4 sont percées dans la paroi 2, entre les rainures 6, des ouïes 7 permettant le passage de l'air chauffé par les ailettes 3.

Grâce à ces ouïes, l'air chauffé peut circuler entre les cartes 8 insérées dans les rainures 6 et réchauffer les composants qu'elles portent. Bien entendu, l'élément chauffant 1 et les ailettes 3 pourraient être disposés différemment sur la paroi guide-cartes 2 par exemple en une position quelconque entre le fond 4 et le côté de la paroi 2 opposé à ce fond. Dans ce cas les ouïes pourraient être réparties de part et d'autres des ailettes 3.

Le dispositif de réchauffage selon l'invention assure le réchauffage des composants selon divers modes d'échanges thermiques possibles :
- par conduction des masses métalliques ou bonnes conductrices thermiques; ce mode est d'autant plus efficace que les cartes électroniques sont munies de drains thermiques (c'est-à-dire d'une couche, métallique en général, recouvrant toute la carte tout en laissant le passage pour les pattes des composants et des connecteurs) ;
- par rayonnement, dans l'environnement proche, de l'élément chauffant ;
- par convection naturelle surtout.

Dans le cas où on utilise seulement ces modes d'échanges thermiques, la convection naturelle doit être favorisée ce qui est obtenu selon le schéma de la figure 2. Sur ce schéma, on voit que l'on a disposé les parois guide-cartes 2 verticalement selon l'axe zz', le fond 4 étant en haut. L'air chauffé au contact des ailettes 3 circule selon les flèches a et b en passant par les ouïes 7 puis entre les cartes.

On peut améliorer encore l'efficacité et la souplesse d'utilisation du dispositif selon l'invention en prévoyant une convection forcée. Pour cela on dispose un ou des ventilateurs 9 ou turbines sur les cycles de convection naturelle a et b, comme représenté sur les figures 3 ou 4. Les ventilateurs 9 sont par exemple disposés à l'opposée du fond 4 par rapport aux cartes. Ces ventilateurs accélèrent la circulation d'air et, comme la circulation est forcée, la position de l'ensemble dans l'espace peut être quelconque. Ainsi les figures 3 et 4 représentent deux positions différentes possibles.

Il est clair que, dans tous les cas, la puissance thermique de l'élément chauffant, la surface des ailettes et leur nombre, leur position, la section des ouïes sont déterminés en fonction des cartes et des composants utilisés, de la température basse de départ, du temps de démarrage désiré à partir de la température basse, du volume et de la capacité calorifique globale du coffret.

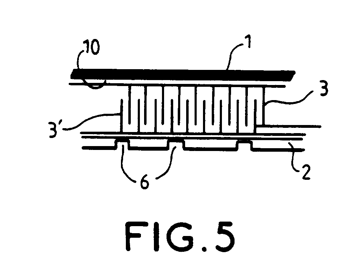

La figure 5 représente partiellement une variante du dispositif selon l'invention plus particulièrement adapté au cas de la convection forcée. Dans cette variante, I'élément chauffant 1 n'est plus disposé directement sur la paroi guide-cartes 2 mais sur un support 10. Le support 10 doit être tel que les ailettes 3 associées à l'élément chauffant 1 se trouvent dans le courant de circulation forcée de l'air vers les ouïes et les cartes.

Ces ailettes 3 peuvent être utilisées seules ou bien on peut prévoir, comme sur la figure 5, un autre jeu d'ailettes 3' fixées sur la paroi guide-cartes 2 et intercalées entre les ailettes 3 pour améliorer les échanges thermiques vers la paroi 2 et, par conduction, vers les cartes 8 et leurs drains thermiques éventuels.

Il est évident que le dispositif de réchauffage est mis en service et arrêté à l'aide d'un circuit de régulation thermique quelconque en fonction de la température requise pour le fonctionnement correct des composants.

Bien entendu, les exemples de réalisation décrits ne sont nullement limitatifs de l'invention.

## Revendications

1. Dispositif de réchauffage de cartes électroniques montées entre des parois guide-cartes (2) opposées comportant des rainures (6) de guidage parallèles et un fond (4) assurant les interconnexions (5), ledit dispositif étant caractérisé en ce qu'un élément chauffant (1) est disposé sur au moins une des parois guide-cartes (2), sur la face opposée aux rainures (8), en ce que des moyens de convection (3) sont associés audit élément chauffant (1) et en ce que lesdites parois guide-cartes (2) comportent des ouïes (7) disposées entre les rainures (6) pour assurer la circulation de l'air chauffé entre les cartes électroniques.

2. Dispositif selon la revendication 1, caractérisé en ce que ledit élément chauffant est disposé sur la paroi guide-cartes (2) le long du côté de cette paroi opposé au fond (4).

3. Dispositif selon la revendication 2, caractérisé en ce que, le chauffage des cartes s'effectuant par convection naturelle, l'air circulant sur les moyens de convection et passant par les ouïes et entre les cartes, lesdites parois guide-cartes (2) sont disposées verticalement avec le fond (4) situé au-dessus.

4. Dispositif selon l'une des revendications 1 ou 2, caractérisé en ce qu'il comprend en outre des moyens de ventilation forcée (9) pour créer une convection forcée par circulation accélérée de l'air entre les cartes, lesdits moyens de ventilation étant insérés sur les cycles de circulation naturelle de l'air entre les cartes, les ouïes et les moyens de convection.

5. Dispositif selon la revendication 4, caractérisé en ce que lesdits moyens de ventilation sont constitués par au moins un ventilateur (9) disposé à l'opposé du fond (4) par rapport aux cartes électroniques (2).

6. Dispositif selon l'une quelconque des revendications 1 à 5, caractérisé en ce que lesdits moyens de convection sont constitués par des ailettes (3) en matériau très bon conducteur thermique disposées parallèlement auxdites rainures (6) sur ledit élément chauffant (1).

7. Dispositif selon la revendication 6, caractérisé en ce que ledit élément chauffant (1) est constitué par un film résistif disposé sur la paroi guide-cartes (2) le long du côté de cette paroi opposé au fond (4).

8. Dispositif de réchauffage de cartes électroniques montées entre des parois guide-cartes (2) opposées comportant des rainures (6) de guidage parallèles et un fond (4) assurant les interconnexions (5), caractérisé en ce que lesdites parois guide-cartes (2) comportent des ouïes (7) disposées entre les rainures (6), en ce que des moyens de ventilation forcée (9), sont prévus pour créer une convection forcée par circulation accélérée de l'air par les ouïes (7) et entre les cartes (8), et en ce qu'un élément chauffant (1) associé à des moyens de convection (3) est disposé de manière telle que lesdits moyens de convection (3) soient situés dans le trajet de ladite circulation d'air.

## Patentansprüche

1. Vorrichtung zum Erwärmen von Elektronikkarten, die zwischen einander gegenüberliegenden Kartenführungswänden (2) angebracht sind, welche zueinander parallele Führungsnuten (6) und einen die Verbindungen (5) gewährleistenden Boden (4) enthalten, wobei die Vorrichtung dadurch gekennzeichnet ist, daß an wenigstens einer der Kartenführungswände (2) an der zu den Nuten (8) entgegengesetzten Fläche ein Heizelement (1) angebracht ist, daß mit dem Heizelement (1) Konvektionsmittel (3) in Verbindung stehen und daß die Kartenführungswände (2) Lufteinlässe (7) enthalten, die zwischen den Nuten (6) angeordnet sind, um die Zirkulation von erwärmter Luft zwischen den Elektronikkarten zu gewährleisten.

2. Vorrichtung nach Anspruch 1, dadurch gekennzeichnet, daß das Heizelement an der Kartenführungswand (2) entlang der zum Boden (4) entgegengesetzten Seite dieser Wand angeordnet ist.

3. Vorrichtung nach Anspruch 2, dadurch gekennzeichnet, daß die Kartenführungswände (2) vertikal mit darüberliegendem Boden (4) angeordnet sind, wenn die Erwärmung der Karten durch natürliche Konvektion bewirkt wird und die Luft durch die Konvektionsmittel zirkuliert sowie durch die Lufteinlässe und zwischen den Karten hindurchströmt.

4. Vorrichtung nach einem der Ansprüche 1 und 2, dadurch gekennzeichnet, daß sie außerdem Zwangsventilationsmittel (9) enthält, um eine Zwangskonvektion durch beschleunigte Luftzirkulation zwischen den Karten zu erzeugen, wobei die Ventilationsmittel in die Kreise der natürlichen Luftzirkulation zwischen den Karten, den Lufteinlässen und den Konvektionsmitteln eingesetzt sind.

5. Vorrichtung nach Anspruch 4, dadurch gekennzeichnet, daß die Ventilationsmittel durch wenigstens einen Ventilator (9) gebildet sind, der bezüglich der Elektronikkarten (2) auf der zum Boden (4) entgegengesetzten Seite angeordnet ist.

6. Vorrichtung nach einem der Ansprüche 1 bis 5, dadurch gekennzeichnet, daß die Konvektionsmittel durch Rippen (3) aus einem sehr gut wärme leitenden Material gebildet sind, die parallel zu den Nuten (6) an dem Heizelement (1) angeordnet sind.

7. Vorrichtung nach Anspruch 6, dadurch gekennzeichnet, daß das Heizelement (1) durch einen Widerstandsfilm gebildet ist, der an der Kartenführungswand (2) entlang der zum Boden (4) entgegengesetzten Seite dieser Wand angeordnet ist.

8. Vorrichtung zum Erwärmen von Elektronikkarten, die zwischen einander gegenüberliegenden Kartenführungswänden (2) angebracht sind, welche zueinander parallele Führungsnuten (6) sowie einen die Verbindungen (5) gewährleistenden Boden (4) enthalten, dadurch gekennzeichnet, daß die Kartenführungswände (2) zwischen den Nuten (6) angeordnete Lufteinlässe (7) enthalten, daß Zwangsventilationsmittel (9) vorgesehen sind, um durch beschleunigte Zirkulation der Luft durch die Lufteinlässe (7) und zwischen den Karten (8) eine Zwangskonvektion zu erzeugen, und daß ein mit Konvektionsmitteln (3) in Verbindung stehendes Heizelement (1) so angeordnet ist, daß die Konvektionsmittel (3) in der Bahn der Luftzirkulation angeordnet sind.

## Claims

1. Device for heating up electronic boards mounted between opposing board-guide walls (2) containing parallel guidance grooves (6) and a back (4) allowing for the interconnections (5), said device being characterized in that a heating element (1) is arranged on at least one of the board-guide walls (2), on the opposite face to the grooves (8), in that convection means (3) are associated with said heating element (1) and in that said board-guide walls (2) contain vents (7) arranged between the grooves (6) so as to allow for the circulation of the heated air between the electronic boards.

2. Device according to Claim 1, characterized in that said heating element is arranged on the board-guide wall (2) along that side of this wall away from the back (4).

3. Device according to Claim 2, characterized in that the heating of the boards being undertaken by natural convection, the air circulating over the convection means and passing through the vents and between the boards, said board-guide walls (2) are arranged vertically with the back (4) situated on top.

4. Device according to one of Claims 1 or 2, characterized in that it furthermore comprises means (9) of forced ventilation for creating a forced convection by accelerated circulation of the air between the boards, said ventilation means being inserted in the loops of natural circulation of the air between the boards, the vents and the convection means.

5. Device according to Claim 4, characterized in that said ventilation means consist of at least one fan (9) arranged away from the back (4) with respect to the electronic boards (2).

6. Device according to any one of Claims 1 to 5, characterized in that said convection means consist of fins (3) which are made of a material which is a very good heat conductor and are arranged parallel to said grooves (6) on said heating element (1).

7. Device according to Claim 6, characterized in that said heating element (1) consists of a resistive film arranged on the board-guide wall (2) along that side of this wall away from the back (4).

8. Device for heating up electronic boards mounted between opposing board-guide walls (2) containing parallel guidance grooves (6) and a back (4) allowing for the interconnections (5), characterized in that said board-guide walls (2) contain vents (7) arranged between the grooves (6), in that means (9) of forced ventilation are provided so as to create forced convection by accelerated circulation of the air through the vents (7) and between the boards (8), and in that a heating element (1) associated with convection means (3) is arranged in such a way that said convection means (3) are situated in the path of said circulation of air.
